(19) Europäisches Patentamt
European Patent Office
Office européen des brevets

(11) **EP 1 442 318 B1**

(12) **EUROPÄISCHE PATENTSCHRIFT**

(45) Veröffentlichungstag und Bekanntmachung des Hinweises auf die Patenterteilung:
**21.03.2012 Patentblatt 2012/12**

(21) Anmeldenummer: **02802605.2**

(22) Anmeldetag: **05.11.2002**

(51) Int Cl.:
*G01S 13/82* *(2006.01)*    *G01S 13/84* *(2006.01)*
*G01S 13/87* *(2006.01)*

(86) Internationale Anmeldenummer:
**PCT/DE2002/004098**

(87) Internationale Veröffentlichungsnummer:
**WO 2003/040753 (15.05.2003 Gazette 2003/20)**

(54) **TRANSPONDERSYSTEM UND VERFAHREN ZUR ENTFERNUNGSMESSUNG**

TRANSPONDER SYSTEM AND METHOD FOR MEASUREMENT OF SEPARATION

SYSTEME TRANSPONDEUR ET PROCEDE DE TELEMETRIE

(84) Benannte Vertragsstaaten:
**DE FR GB**

(30) Priorität: **09.11.2001 DE 10155251**

(43) Veröffentlichungstag der Anmeldung:
**04.08.2004 Patentblatt 2004/32**

(73) Patentinhaber: **Symeo GmbH**
**85579 Neubiberg (DE)**

(72) Erfinder:
• **NALEZINSKI, Martin**
**81541 München (DE)**
• **VOSSIEK, Martin**
**31139 Hildesheim (DE)**
• **WIEBKING, Leif**
**80805 München (DE)**
• **HEIDE, Patric**
**85591 Vaterstetten (DE)**

(74) Vertreter: **Schulze, Mark**
**Von Lieres Brachmann Schulze**
**Patentanwälte**
**Grillparzerstrasse 12A**
**81675 München (DE)**

(56) Entgegenhaltungen:
WO-A-01/67625    DE-A- 19 946 161
DE-A1- 10 032 822    US-A- 2 786 996

**Beschreibung**

Die Erfindung bezieht sich auf ein Verfahren zur Entfernungsbestimmung mit den oberbegrifflichen Merkmalen des Anspruchs 1, ein Entfernungs-Bestimmungssystem mit den oberbegrifflichen Merkmalen des Patentanspruchs 2 bzw. eine Basisstation und einen Transponder dafür.

Transpondersysteme sowie Verfahren und Anordnungen zum Austausch von Daten und zur Messung der Entfernung von einer Basisstation zu einem modulierten Transponder existieren in vielfältiger Form und sind seit langem bekannt. Allgemeine Ausführungsformen und Prinzipien finden sich z.B. in "K. Finkenzeller, RFID-Handbuch, 2 ed. München, Wien: Carl Hanser Verlag, 2000". Als Transponder üblich sind z.B. sogenannte Rückstreu- bzw. Backscatter-Tranäponder, die über keine eigene Signalquelle verfügen, sonder das empfangene Signal lediglich, gegebenenfalls verstärkt, zurückspiegeln.

Im folgenden Text werden solche Systeme, bei denen der Abstand zwischen der Basisstation und dem Transponder gemessen werden kann, allgemein als Funkfrequenz-gestützte Lokalisierungssysteme bzw. RFLO-Systeme (Radio Frequency LOcalisation) bezeichnet, dies analog zu Funkfrequenz-gestützter Identifizierung bzw. RFID (Radio Frequency Identifikation). Vorteilhafte Ausführungen von derartigen RFLO-Anordnungen, die auf dem Prinzip des FM-CW-Radars (Frequency Modulated Continous wave / frequenzmodulierte kontinuierliche Welle) bzw. verwandten Prinzipien beruhen, sind z.B. in "M. Vossiek, R. Roskosch, and P. Heide, Precise 3-D Object Position Tracking using FMCW Radar, 29th European Microwave Conference, Munich, Germany, 1999" und in DE 199 46 161, DE 199 57 536 und DE 199 57 557 ausführlich beschrieben. DE 199 46 161 zeigt Verfahren zur Abstandmessung zu einem Transponder auf, wobei hier FMCW-Backscatter-Transponder und -Systeme in klassischen Ausführung beschrieben werden. DE 199 57 536 und DE 199 57 549 beschreiben KFZ-Zugangssysteme, insbesondere Diebstahlschutzsysteme, Ausführungen und Applikation unter anderem auch mit FMCW-Backscatter-Transponder.

Nachteilig ist bei derartigen RFLO-Backscattersystemen, dass das gesendete Signal den Weg von der Basisstation zum Transponder hin und zurück durchlaufen muss und daher, basierend auf der Radargleichung, das Signal-zu-Rauschverhältnis (SNR) der gesamten Übertragungstrecke proportional zur 4ten Potenz der Entfernung abnimmt. Wegen der mit der Frequenz stark ansteigenden Freifelddämpfung lassen sich insbesondere sehr hochfrequente passive Backscatter-Transponder im GHz-Bereich kaum mit einem befriedigenden Signal-zu-Rauschverhältnis realisieren. Dies ist insbesondere deswegen unbefriedigend, da GHz-Systeme im Prinzip wegen der hohen verfügbaren Bandbreite sowohl zur Entfernungsmessung als auch zur schnellen Datenübertragung sehr vorteilhaft einsetzbar wären.

Wird im Transponder mit einer eigenen Quelle, basierend auf dem empfangenen Signal, ein phasenkohärentes neues Signal generiert, so durchläuft ein Signal den Weg Basisstation/Transponder jeweils nur einmal. In diesem Fall ist das Signal-zu-Rauschverhältnis nur umgekehrt proportional zur 2-ten Potenz der Entfernung. Hinzu kommt, dass auch sonstige Dämpfungen und Verluste auf dem Übertragungsweg nur einmal und nicht zweimal auf das zurückübertragene Signal einwirken. Daher ist, insbesondere bei größeren Entfernung, das Signal-zu-Rauschverhältnis hierbei um Größenordnungen höher als bei einfachen Backscattersystemen. Allerdings sind derartige Systeme z.B. bezüglich Schaltungskomponenten, Stromverbrauch, Herstellungs- und Unterhaltungskosten sehr viel aufwendiger als die genannten passiven Backscatter-Anordnungen und kommen daher für sehr viele Applikationen nicht in Betracht.

Ein weiteres grundlegendes Problem von RFLO-Backscattersystemen besteht, wie DE 199 46 161 und "M. Vossiek, R. Roskosch, and P. Heide, Precise 3-D Object Position Tracking using FMCW Radar, 29th European Microwave Conference, Munich, Germany, 1999" zu entnehmen ist, darin, dass sie häufig nicht in der Lage sind, sehr kurze Distanzen zwischen Transponder und Basisstation zuverlässig zu messen. Gerade diese kurzen Distanzen sind aber z.B. für Zugangssysteme und lokale Positioniersysteme (LPS) besonders interessant. Das Problem rührt daher, dass es in erster Linie aus rechtlichen aber auch aus technische Gründen nicht möglich ist, beliebig große Modulationsbandbreiten B zu verwenden.

Wie dies in den genannten Literaturstellen dargestellt ist, ergeben sich z.B. beim FMCW-Backscatter-RFLO zwei Spektralkomponenten deren Abstand bezüglich Frequenz oder Phase proportional zur Entfernung "dist" zwischen dem Transponder und der Basisstation ist. Die begrenzte Modulationsbandbreite bewirkt nun, dass die Spektralkomponenten nicht beliebig schmal sind, sondern bei üblicher Auswertung über die Fouriertransformation physikalisch bedingt zumindest die Breite $\Delta p = c/(2*B)$ aufweisen, wobei c die Lichtgeschwindigkeit, B die Modulationsbandbreite und $\Delta p$ die Distanz ist, hier in Metern umgerechnet.

Die physikalisch sinnvolle Frequenz einer Spektralkomponente entspricht ihrem Maximalwert, der üblicherweise in ihrer Mitte liegt. Bei Unterschreiten einer gewissen Mindestentfernung überlappen die Spektralkomponenten. Dies führt dazu, dass das Maximum der Spektralkomponente nicht mehr der physikalisch sinnvollen Frequenz entspricht und somit kein einfach ablesbares Maß zur Bestimmung der Frequenz vorhanden ist und daher die Entfernung nicht mehr exakt bestimmt werden kann. Auch können die beiden Spektrallinien so weit ineinander laufen, dass sie nicht mehr als getrennte Linien erkennbar sind. Wird z.B. mit einer Bandbreite von 80 MHz gemessen, wie sie z.B. im gängigen, weltweit verfügbaren und standardisierten ISM-Radarband (ISM = Industrial-Scientific-Medical) bei 2,45 GHz maximal verfügbar ist, so sind mit einfachen Anordnungen üblicherweise unter ca. 2 m Mindestabstand zwischen Basisstation und Transponder keine exakten Messwerte mehr zu detektieren. Praktisch ist dies üblicherweise sogar nicht unter 4 m möglich, da zur Berechnung der Fouriertransformation üblicherweise das Zeitsignal mit einer Fensterfunktion gewichtet wird, die eine weitere Verschlechterung der Auflösung bewirkt.

Dieses Problem kann, gemäß "M. Vossiek, R. Roskosch, and P. Heide, Precise 3-D Object Position Tracking using FMCW Radar, 29th European Microwave Conference, Munich, Germany, 1999", durch Verwendung einer Verzögerungsleitung gelöst werden, die eine feste Grundlaufzeit des Signals bewirkt. Neben dem schaltungstechnischen Mehraufwand verursacht jede Totzeit im Transponder jedoch erhebliche Probleme bezüglich Drift und den daraus resultierenden Messungenauigkeiten.

Die DE 199 46 161 A1 offenbart ein Verfahren zur Abstandsmessung. Bei diesem Verfahren wird mittels eines CW-Mikrowellensensors ein Abstand zu mindestens einem Messobjekt gemessen, und es ist dadurch gekennzeichnet, dass an dem mindestens einen Messobjekt mindestens ein aktiver Reflektor befestigt ist, welcher ein vom CW-Mikrowellensensor ausgesandtes Signal empfängt, moduliert und danach abstrahlt.

Die US 2,786,996 offenbart ein Messsystem auf der Grundlage von elektromagnetischen Wellen. Anhand des Messsystems wird die Geschwindigkeit zwischen zwei Stationen bestimmt. Es wird eine Abfragestation offenbart zur Erzeugung und zum Senden eines kontinuierlichen Wellensignals mit einer Referenzfrequenz. Weiterhin wird eine Sendeantwortstation zum Empfangen des kontinuierlichen Wellensignals und zum gleichzeitigen Erzeugen und Senden eines Antwortsignals offenbart, das periodische Impulse einer Welle aufweist, die kohärent in Frequenz und Phase mit dem empfangenen kontinuierlichen Wellensignal ist. Die Abfragestation empfängt das Antwortwellensignal zusammen mit einem Abschnitt der erzeugten Welle mit der Referenzfrequenz. Zudem wandelt sich Abfragestation die empfangene Welle und die Welle der Referenzfrequenz zur Erzeugung einer Welle mit einer Dopplerfrequenz um. Auf der Grundlage der Dopplerfrequenzwelle wird die relative Geschwindigkeit beider Stationen gemessen.

Aus WO 01/67625 A1 ist einen Transponder mit einem "quenched" Oszillator ("quench" = Unterdrückung einer Schwingung) bekannt, welcher mittels eines "quench" Signals angeregt wird. Ein "locked" Oszillator ist außerdem als eine spezielle Ausführungsform des "quenched" Oszillators offenbart, mit besseren Eigenschaften als ein normaler "injection locked" Oszillator. Als weitere Alternative wird ein "super regenerative" Oszillator offenbart welcher hervorragende verstärkungseigenschaften aufweist. Das Transpondersystem dient zur Entfernungsbestimmung zwischen einer Basisstation und dem Transponder. Das vom Transponder empfangene Signal synchronisiert den Oszillator und dieses so erzeugte Signal wird wieder vom Transponder ausgestrahlt.

Die Aufgabe der Erfindung besteht darin, ein besonders einfaches Verfahren aufzuzeigen, mit dem es möglich ist, die Entfernung zu einem Transponder bis in den Nahbereich auf alternative Art und Weise zu bestimmen.

Diese Aufgabe wird durch das Verfahren zur Entfernungsmessung mit den Merkmalen des Patentanspruchs 1 das Entfernungs-Bestimmungssystem mit den Merkmalen des Patentanspruchs 2, bzw. Basisstationen und Transpondern dafür gelöst. Vorteilhafte Ausgestaltungen sind Gegenstand von abhängigen Ansprüchen.

Das Transpondersystem und das Verfahren zur Entfernungsmessung ermöglichen es, die Entfernung zu einem Transponder bis in den Nahbereich sehr exakt zu bestimmen. Desweiteren wird eine aufbautechnische Lösung ermöglicht, die eine besonders bau- und kostengünstige Umsetzung der Anordnung erlaubt. Ferner werden Auswertemethoden ermöglicht, die eine besonders vorteilhafte Auswertung der Messsignale erlauben und daher eine hohe Zuverlässigkeit und Genauigkeit der Messung ermöglichen.

Wenn die Entfernungs-Bestimmungseinrichtung in der Basisstation einen Mischer zum Mischen des von dem Transponder empfangenen quasi-phasenkohärenten Signals und des momentanen Sendesignals zu einem Mischsignal aufweist, so entsteht ein Meßsignal, das zumindest 2 Spektralkomponenten aufweist, deren Frequenzabstand oder Phasenabstand ein Maß für Entfernung von der Basisstation zum Transponder ist, wobei dieses Maß von der Ein- und Ausschaltfrequenz des Oszillators im Transponder unabhängig ist.

Die Modulationsfrequenz des Sendesignals der Basisstation zu modulieren bzw. zu verstimmen, führt letztendlich zu einem Messsignal welches Spektralanteile aufweist, welche durch Cosinus-Funktionen ausgedrückt werden, die amplitudengewichtet sind. Vorteilhafterweise wird durch eine dem beschriebenen Transponder zueigenen Frequenzverschiebung, eine Messung auch von kleinen Entfernungen bis zu einem Wert von Null herab möglich. Das außerdem mögliche Durchführen einer Fouriertransformation des amplitudengewichteten Messsignals in den Frequenzbereich führt zu Spektrallinien (Seitenbändern) mit einer Rechteck-förmigen Einhüllenden, bei der die äußeren, der Modulationsfrequenz am nächsten liegenden Kanten eines linken und rechten Seitenbandes die Entfernung zwischen Basisstation und Transponder bestimmen.

Transponder bzw. Basisstation als LTCC-Modul (Low Temperature Cofired Ceramic) oder unter Verwendung zumindest eines LTCC-Moduls (LM) auszubilden, ermöglicht kleine und kostengünstige Bauweisen.

Dadurch, dass die Modulationsfrequenz zum Ein- und Ausschalten des Oszillators im Transponder nicht in die Auswertung der Entfernung in der Basisstation eingeht, kann sie zum Übertragen von zusätzlichen Informationen vom Transponder zur Basisstation verwendet werden.

Die Modulationsfrequenz zum Ein- und Ausschalten des Oszillators im Transponder jedem einzelnen einer Vielzahl von Transpondern individuell zuzuweisen, ermöglicht ein gezieltes Ansprechen verschiedener Transponder im Sendebereich einer Basisstation.

Ein Ausführungsbeispiel wird nachfolgend anhand der Zeichnung näher erläutert. Es zeigen:

Fig. 1 eine beispielhafte Anordnung einer Basisstation und eines Transponders, die miteinander kommunizieren;

Fig. 2 und 3 beispielhafte Demodulatoren für eine solche Basisstation;

Fig. 4 Modulationskomponenten nach einer Verarbeitung gemäß dem Stand der Technik bzw. dem vorliegenden Verfahren;

Fig. 5 Frequenz/Phasendiagramme dazu;

Fig. 6 verwendbare Parameter für eine beispielhafte Anordnung;

Fig. 7 eine Schaltungsanordnung mit beispielhaften Parameterwerten;

Fig. 8 einen Transponder mit LTCC-HF-Modulen;

Fig. 9 einen Aufbau eines solchen LTCC-Moduls und

Fig. 10 ein beispielhaftes Frequenzspektrum von Echosignalen, wie sie als Echosignale empfangen werden.

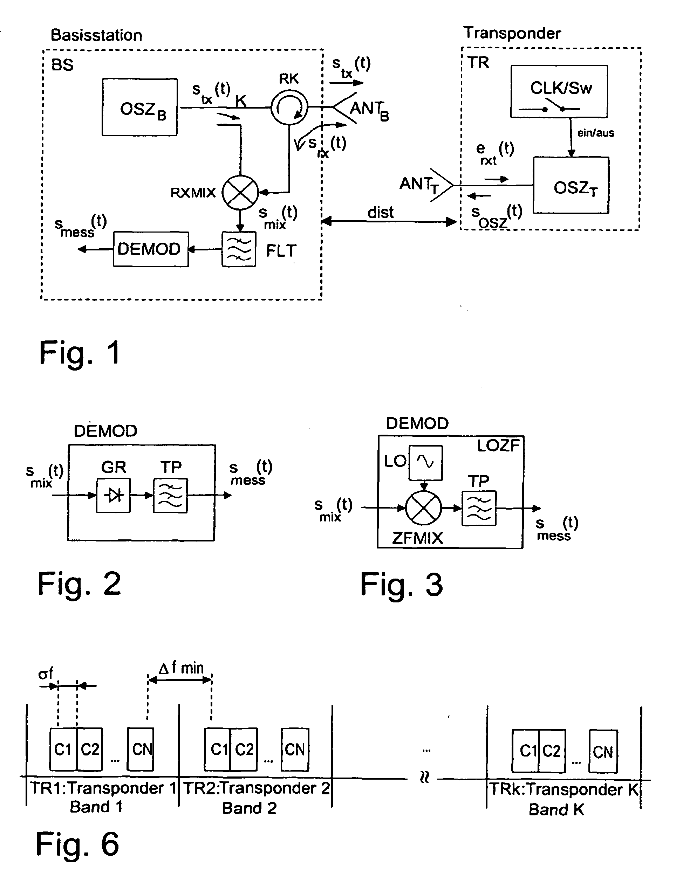

Wie aus Fig. 1 ersichtlich, weist eine beispielhafte Anordnung einer Basisstation BS und eines Transponders TR, die miteinander kommunizieren, eine Vielzahl von Einzelkomponenten auf.

Die Basisstation BS umfasst insbesondere einen Oszillator $OSZ_B$ zum Erzeugen eines oszillierenden Signals $s_{tx}(t)$, welches an einem Oszillatorausgang ausgegeben wird bzw. abgegriffen werden kann. Der Oszillatorausgang ist mit einer Sendeantenne verbunden, die optional zugleich auch als Empfangsantenne $ANT_B$ verwendet werden kann, wie dies hier dargestellt ist, so dass das Signal $s_{tx}(t)$ über die Antenne $ANT_B$ abgestrahlt werden kann.

Vorliegend ist in der Basisstation BS zwischen Oszillatorausgang und Antenne $ANT_B$ ein Richtkoppler RK geschaltet. Dieser weist einen weiteren Ausgang auf, der zu einem Mischer RXMIX und weiteren Komponenten führt.

Der Transponder TR weist eine Antenne $ANT_T$ auf, mit der das Signal der Basisstation BS, das mit dem Oszillator $OSZ_B$ generiert und über die Antenne $ANT_B$ ausgesendet wurde, als Empfangssignal $e_{rxt}(t)$ empfangen werden kann. Beim vorliegenden Beispiel dient die Antenne vorteilhafterweise auch als Sendeantenne $ANT_T$.

Außerdem weist der Transponder TR einen mit der Antenne $ANT_T$ verbundenen Oszillator $OSZ_T$ auf. Zum Anregen des Oszillators $OSZ_T$ ist außerdem eine Taktsteuerung CKL/Sw bereitgestellt. Der Oszillator $OSZ_T$ wird mit der Taktsteuerung CLK/Sw zyklisch mit einer Frequenz für ein- und ausgeschaltet. Das vom Oszillator $OSZ_T$ generierte Signal $s_{osz}(t)$ wird dabei quasi-kohärent zu dem Vergleichssignal $sig_{IN}$. Durch das Ein- und Ausschalten des Oszillators $OSZ_T$ wird auch seine quasiphasenkohärente Anregbarkeit geschaltet.

Der Oszillator 2 ist vorteilhafterweise so ausgebildet, dass er einerseits nicht durch thermisches Rauschen zur Oszillation angeregt wird, aber andererseits das auf ihn eingekoppelte Empfangs- bzw. Basissignal $e_{rxt}(t)$ ausreicht, um zum Basissignal $e_{rxt}(t)$ quasiphasenkohärente Oszillationen anzuregen. Quasiphasenkohärent heißt dabei insbesondere auch, dass die Phasendifferenz zwischen dem Basissignal und dem erzeugten Vergleichssignal klein ist, wobei der Begriff klein in Bezug zur beabsichtigten Kommunikations- bzw. Messaufgabe zu sehen ist. Als Grenze für eine kleine Phasenabweichung wird zum Beispiel häufig der Wert $\pi/10$, also ca. 20° verwendet. Solche Signale mit nur kleinen Phasenabweichungen werden im Folgenden quasiphasenkohärent bezeichnet und die Zeitspanne, in der diese Kohärenz besteht, als Kohärenzzeitlänge.

Zweckmäßig ist hierbei, dass nicht nur die Oszillationen des aktiven Oszillators quasiphasenkohärent zum Basissignal sind, sondern bereits die Anregung des aktiven Oszillators quasi-phasenkohärent geschieht. Während bei Vorrichtungen und Verfahren nach dem Stand der Technik das Anregen des aktiven Oszillators durch thermisches Rauschen erfolgt, und seine Oszillationen erst später durch einen aufwendigen Regelprozess und ein Lock-In phasenkohärent ermöglicht werden, wird der Oszillator hier vorteilhafterweise bereits durch das Basissignal quasiphasenkohärent angeregt bzw. schwingt bereits quasiphasenkohärent an, so dass damit gleichsam automatisch die Phasenkohärenz hergestellt wird.

Somit wird im Transponder TR ein mehr oder weniger großer Teil eines Empfangs- bzw. Basissignals $e_{rxt}(t)$ auf den Oszillator $OSZ_T$ gekoppelt. Vorzugsweise handelt es sich um ein elektrisches Basissignal und ein entsprechendes Oszillatorsignal. Realisierbar ist prinzipiell aber auch eine Anordnung unter Verwendung optischer, akustischer oder anderer Signale. Das Empfangs- bzw. Basissignal $e_{rxt}(t)$ regt den Oszillator $OSZ_T$ quasiphasenkohärent zu Oszillationen an, wodurch dieser ein Oszillatorsignal erzeugt, welches aus dem Oszillator als das Signal $s_{osz}(t)$ ausgekoppelt und über einen Ausgang abgeleitet wird. Der Eingang für das Empfangs- bzw. Basissignal $e_{rxt}(t)$ und der Ausgang für das Oszillatorsignal B können ganz oder teilweise identisch sein. Sie können aber auch getrennt voneinander realisiert werden.

Das im Transponder TR generierte Signal $s_{osz}(t)$ wird mittels der Antenne $ANT_T$ des Transponders TR zur Basisstation BS zurück gesendet und von dieser mit der Antenne $ANT_B$ empfangen.

Über den Richtkoppler RK wird in der Basisstation BS das derart empfangene Signal von einem momentan gesendeten Signal getrennt und im Mischer RXMIX mit einem Teil des momentan erzeugten Signals von dem Oszillator $OSZ_B$ der Basisstation gemischt.

Mit einem dem Mischer RXMIX nachgeschalteten Filter FLT werden nicht interessierende Mischkomponenten unterdrückt. Vorzugsweise wird dieses Filter FLT der Basisstation BS als Bandpassfilter ausgeführt, wobei die Mittenfrequenz der Taktrate der Taktsteuerung CLK/Sw des Transponders TR angepaßt sein sollte.

Die beispielhafte Basisstation ist somit wie ein gängiges FMCW-Radargerät ausgeführt, wobei die dargestellte Topologie nur ein Beispiel darstellt, im Prinzip aber beliebige übliche Ausführungen von Radaren mit Frequenzmodulation verwendet werden können. Vorteilhafterweise sind lediglich die Komponenten hinter dem Empfangsmischer RXMIX und die Signalauswertung entsprechend der Modulation im Transponder TR anzupassen.

Die Funktion des vorteilhaften Verfahrens zur Entfernungsmessung läßt sich herleiten, wie folgt:

Als Sendesignal $s_{tx}(t)$ der Basisstation wird zunächst ein monofrequentes Signal der Form

$$s_{tx}(t) = \sin(\omega_c + \omega_{sw}) \cdot t + \phi_0$$

angenommen, wobei $\omega_c$ die Mittenfrequenz, $\omega_{sw}$ eine zunächst feste Modulationsfrequenz, t die Zeit und $\phi_0$ einen beliebigen Phasenoffset darstellen. Dieses Signal wird von der Basisstation zum Transponder gesendet une trifft um die Laufzeit $\tau/2$, mit $\tau/2 = dist/c$, dist als Entfernung zwischen Basisstation BS und Transponder TR und c als Lichtgeschwindigkeit, verzögert bein Transponder TR als Transponder-Empfangssignal $e_{rxt}(t) = s_{tx}(t-\tau/2)$ ein. Wie oben dargestellt ist, wird der Oszillator $OSZ_T$ des Transponders TR zyklisch ein- und ausgeschaltet bzw. ausgeschaltet wird, wird im folgenden mit Ts bezeichnet, wobei $Ts = 1 / (2f_{mk})$ entspricht.

Bei jedem Einschaltvorgang schwingt der Oszillator $OSZ_T$ bei bevorzugter Anordnung exakt mit der aktuellen Phase von $e_{rxt}(t)$ auf seiner Schwingfrequenz $\omega_{osz}$ an. Wird der Oszillator z.B. zum Zeitpunkt $t = -\tau/2$ eingeschaltet, so schwingt er mit der Phase

$$\phi_i = \arg\{s_{rxt}(-\frac{\tau}{2})\} = \arg\{s_{tx}(-\tau)\} = (\omega_c + \omega_{sw}) \cdot (-\tau) + \phi_0$$

an und das Oszillatorsignal $s_{osz}(t)$ entspricht demzufolge:

$$s_{osz}(t) = \sin(\omega_{osz} \cdot \left(t + \frac{\tau}{2}\right) - (\omega_c + \omega_{sw}) \cdot \tau + \phi_0) \ .$$

Das Oszillatorsignal $s_{osz}(t)$ gelangt dann, wiederum um die Laufzeit $\tau/2$ verzögert, als Empfangssignal $s_{rx}(t)$ mit

$$s_{rx}(t) = s_{osz}(t - \frac{\tau}{2}) = \sin(\omega_{osz} \cdot t - (\omega_c + \omega_{sw}) \cdot \tau + \phi_0)$$

zur Basisstation BS und wird in dieser mit dem aktuellen Sendesignal $s_{tx}(t)$ gemischt. Vernachlässigt man die hochfrequenten Mischprodukte und geht man vereinfacht davon aus, dass $\omega_{osz} = \omega_c$ ist, was bei geeigneter Wahl von $\omega_{sw}$ ohne Einschränkung der Allgemeinheit möglich ist, so ergibt sich für das Mischsignal $s_{mix}(t)$

$$s_{mix}(t) = \cos(t \cdot \omega_{sw} + \tau \cdot (\omega_c + \omega_{sw})) \, .$$

Im folgenden wird nun davon ausgegangen, dass hinter dem Empfangsmischer RXMIX elektronische Komponenten/Mittel DEMOD vorgesehen sind, die dazu führen, dass die zeitliche Änderung der Spannung im Zeitintervall zwischen Ein- und Ausschalten, also von 0..Ts, im Sinne einer Mittelung zu eliminieren ist. Ein einfacher Hüllkurven-Demodulator nach dem Stand der Technik, bei dem das Signal gleichgerichtet und anschließend tiefpassgefiltert wird, würde z.B. in diesem Sinn arbeiten. Eine Ausführung eines solchen einfachen Demodulators DEMOD mit einem Gleichrichter GR und dem Tiefpassfilter TP zeigt Fig. 2.

Eine vorteilhaftere, in Fig. 3 skizzierte Variante eines Demodulators DEMOD besteht darin, dass Misch-Signal vorzugsweise mit einer Frequenz in der Nähe oder gleich der zyklischen Frequenz $f_{mk}$ der Taktsteuerung CLK/Sw auf eine niedrige Frequenz herunterzumischen und anschließend mit einem Filter TP, das zumindest ein Tiefpass-Verhalten aufweist, zu filtern. Eine mögliche Ausführung dieser Variante weist einen Lokaloszillator LOZF, einen Mischer ZFMIX und einen Tiefpaß TP auf. Wird die Frequenz des Lokaloszillators LOZF so ausgelegt, dass negative Mischfrequenzen entstehen können, so ist der Mischer ZFMIX, wie dies allgemein bekannt ist, als IQ-Mischer (IQ: In-Phase und Quadratur-Phase, d.h. 90° phasenverschoben), der Real- und Imaginärteil liefert, auszulegen. Anstelle des Tiefpassfilters TP ist z.B. auch ein Bandpassfilter einsetzbar.

Im Zeitintervall 0 bis TS betrachtet, bewirken die dargestellten Mittel, dass eine Art Effektivwert der Spannung vom Mischsignal $s_{mix}(t)$ bestimmt wird. Dieser Effektivwert bildet dann im folgenden das eigentliche Messsignal $s_{mess}(t)$. Konstante Amplitudenfaktoren werden bei der folgenden Darstellung ohne Verlust an Allgemeingültigkeit vernachlässigt. Der Effektivwert von $s_{mix}(t)$ im Zeitintervall 0 bis TS, also $S_{mess}(t)$, berechnet sich, wie folgt:

$$s_{mess}(t) = \int_0^{Ts} s_{mix}(t) = const. \cdot \frac{\cos\left(\omega_c \cdot \tau + \omega_{sw} \cdot \tau + \frac{1}{2} \cdot T_s \cdot \omega_{sw}\right) \cdot \sin\left(\frac{1}{2} T_s \cdot \omega_{sw}\right)}{\omega_{sw}} \, .$$

Da das Messsystem vorzugsweise frequenzmoduliert betrieben wird, wird nachfolgend der Fall betrachtet, bei dem die Modulationsfrequenz $\omega_{sw}$ zeitabhängig moduliert wird. Wird $\omega_{sw}$ während einer Zeitdauer von T linear von -B/2 bis +B/2 über die Bandbreite B verstimmt, gilt also

$$\omega_{sw} = \frac{2 \cdot \pi \cdot B \cdot t}{T} \, ,$$

so ergibt sich aus $s_{mess}(t)$ für das resultierende FMCW-Messsignal $S_{messfmcw}(t)$ :

$$s_{messfmcw}(t) = \cos\left(\omega_c \cdot \tau + \frac{2 \cdot \pi \cdot B \cdot t \cdot \tau}{T} + \frac{\pi \cdot B \cdot t \cdot T_s}{T}\right) \cdot \frac{\sin\left(\frac{\pi \cdot B \cdot t \cdot T_s}{T}\right)}{\left(\frac{\pi \cdot B \cdot t}{T}\right)} \, .$$

Wie zuvor dargestellt wurde beschreibt wird in der Herleitung mit dem Signal $S_{messfmcw}(t)$ lediglich das Signal während einer Einschaltperiode exakt widergegeben. Dadurch, das dieses Signal zusätzlich durch die periodische Modulation im Transponder moduliert wird entsteht eine Frequenzverschiebung von $S_{messfmcw}(t)$ bzw. zusätzlich Spektralkomponenten. Da dieser Effekt einer Modulation allgemein bekannt und im zitierten Stand der Technik beschrieben ist, wird im folgenden nur eine einzelne Spektralkomponente exemplarisch betrachtet, bzw. das Signal $s_{messfmcw}(t)$, zunächst so, als sei es nicht zyklisch moduliert worden.

Dieses Messsignal $S_{messfmcw}(t)$ weist nun zwei entscheidende und sehr vorteilhafte Unterschiede zu Signalen von Standard FMCW-Transponder-Systemen auf.

Zum einen ist die gemessene Frequenz $f_{mess}$, die der Ableitung der Phase des cos-Argumentes, also

$$f_{mess} = dist \cdot \frac{2 \cdot B}{T \cdot c} + \frac{B \cdot T_s}{2 \cdot T} = f_{beat} + \Delta b \, ,$$

entspricht, um den Frequenzanteil $\Delta b = B*Ts / (2\,T)$ verschoben. Die Frequenz $f_{beat}$ entspricht der normalen gemessenen FMCW-Frequenz und beinhaltet die eigentliche Messinformation, nämlich die Entfernung zwischen Basisstation BS und Transponder TR mit $\tau = 2\,dist\,/c$. Zum anderen ist das Signal $S_{messfmcw}(t)$ mit einer trigonometrischen, insbesondere Si-Funktion (Si(x) = Sinus(x)/x) amplitudengewichtet. Transformiert man dieses amplitudengewichtete Signal mit der Fouriertransformation in den Frequenzbereich, so werden die hervorragenden messtechnischen Eigenschaften dieses Signals deutlich. Die Fouriertransformierte der vorliegenden Si-Funktion ergibt eine Rechteckfunktion, wobei die Breite $\Delta p$ des Rechtecks

$$\Delta p = \frac{B \cdot T_s}{T}$$

beträgt. Da die Mittenfrequenz $f_{mess}$ des Rechteckes wegen der dargestellten Frequenzverschiebung bei $f_{beat} + \Delta b = f_{beat} + 0.50\Delta p$ liegt, ist sichergestellt, dass das rechte und linke Seitenband der cos-Funktion auch bei der Entfernung 0 nicht ineinander laufen. Das heißt, dass mit dem entsprechenden Transpondersystem, im Prinzip unabhängig von der Bandbreite, problemlos bis zur Entfernung 0 gemessen werden kann. Folglich besitzt dieses System nicht das Nahbereichsproblem vergleichbarer bekannter Verfahren.

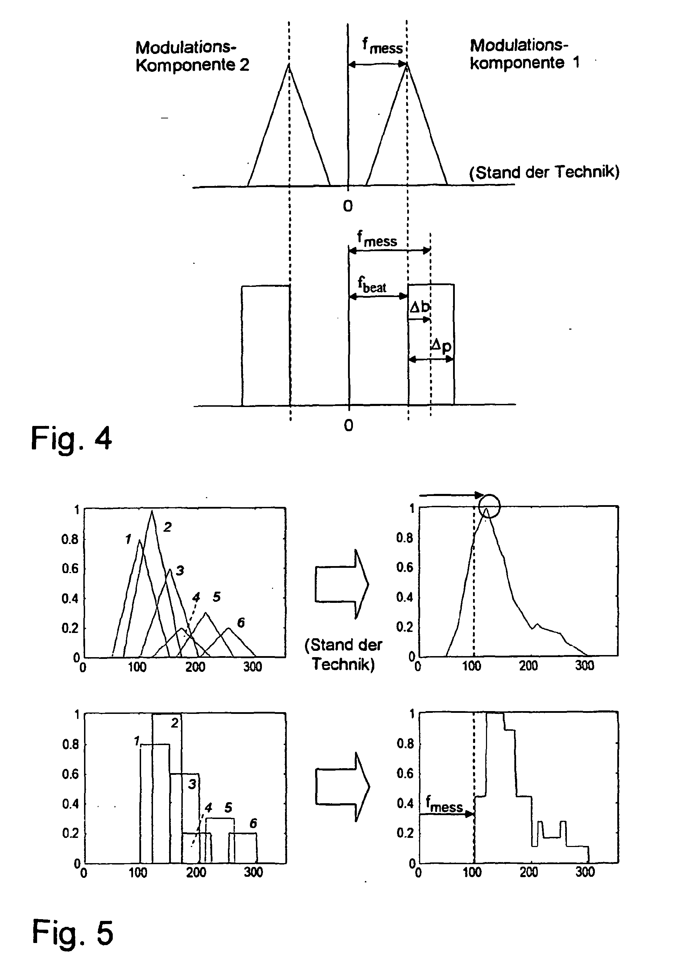

Unterstützt wird diese günstige Eigenschaft dadurch, dass sich als Spektral-Hüllkurve, wie dargestellt wurde, eine Rechteckfunktion ergibt. Folglich kann die Beat-Frequenz $f_{beat}$ und somit die Entfernung zwischen Basisstation BS und Transponder TR anhand des Abstandes zwischen den äußeren Kanten des linken und rechten Seitenbandes bestimmt werden. Den vorstehend beschriebenen Vergleich der Signale von einem konventionellen FMCW-Backscattersystem zu dem vorliegenden System und das Prinzip der Auswertung veranschaulicht Fig. 4.

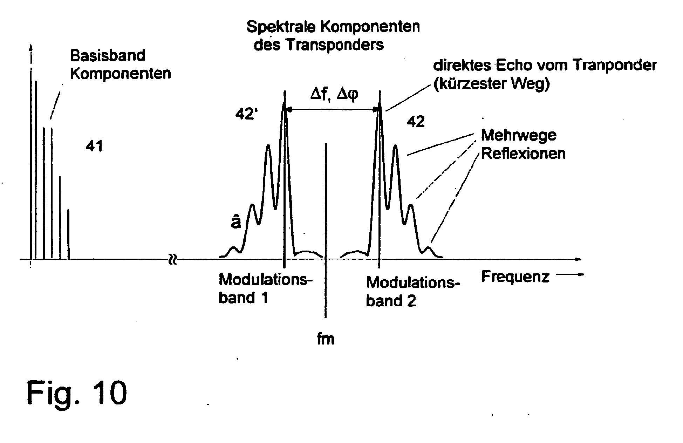

Fig. 10 dient zur allgemeinen Verdeutlichung und stellt das Frequenzspektrum der Echosignale dar, die von der Basisstation BS bei einem FMCW-Backscattersystem als Messsignale (Echosignale) empfangen werden. Die Hüllkurve aller Amplituden ä der Echosignale über dem gesamten Frequenzbereich oder auch nur über einem Ausschnitt daraus wird als Echoprofil bezeichnet, welches auszuwerten ist. Es werden also Amplituden ä, Phasen $\varphi$ und Frequenzen f der Echosignale gemessen und in einer Recheneinheit weiterverarbeitet.

Die Basisstation BS kann nach dem aus der Radartechnik für sich bekannten Prinzip des FM-CW-Verfahrens arbeiten. Dabei wird die Sendefrequenz innerhalb eines vorgegebenen Frequenzbereichs (Bandbreite) geändert. Aus einer Messung der Frequenzdifferenz $\Delta f$ oder der Phasendifferenz $\Delta \varphi$ zwischen Sendefrequenz und Empfangsfrequenz kann eine Entfernung eines Objekts ermittelt werden. Die empfangene Frequenz f oder Phase $\varphi$ sind also proportional einer Entfernung.

Infolge der Frequenzumsetzung durch die Modulation des Transponders befinden sich im oberen Frequenzbereich, entsprechend der beiden Seitenbänder 42 und 42' bei Zweiseitenbandmodulation, Echosignale, die als Echoprofil bzw. Verteilung der Echosignale über Frequenz f und/oder Zeit t zur Auswertung der Echosignale und zur Entfernungsmessung herangezogen werden. Infolge der Modulation ergeben sich zumindest zwei Seitenbänder 42 und 42', die symmetrisch zu der Modulationsfrequenz $f_M$ des Transponders sind. Bei on/off- bzw. Ein/Aus-Modulation entstehen zusätzlich weitere Spektrallinien höherer Modulationskomponenten, die in gleicher Weise ausgewertet werden könnten aber eine geringere Amplitude aufweisen und daher für eine Auswertung eher ungünstig sind und üblicherweise einfach weggefiltert und hier zur Vereinfachung der Beschreibung nicht betrachtet werden. Da die vom Transponder ausgesendeten Echosignale ebenfalls z.T. mehrfach an Objekten reflektiert werden, werden über der Frequenz f mehrere Maximalwerte erhalten, deren zugehörige Frequenzlage jeweils die effektive Länge des Übertragungsweges widerspiegeln. Das Echoprofil eines Seitenbands 42 oder 42' genügt, um eine Auswertung in einer Auswerteeinheit, wie einem Mikroprozessor 27 vorzunehmen.

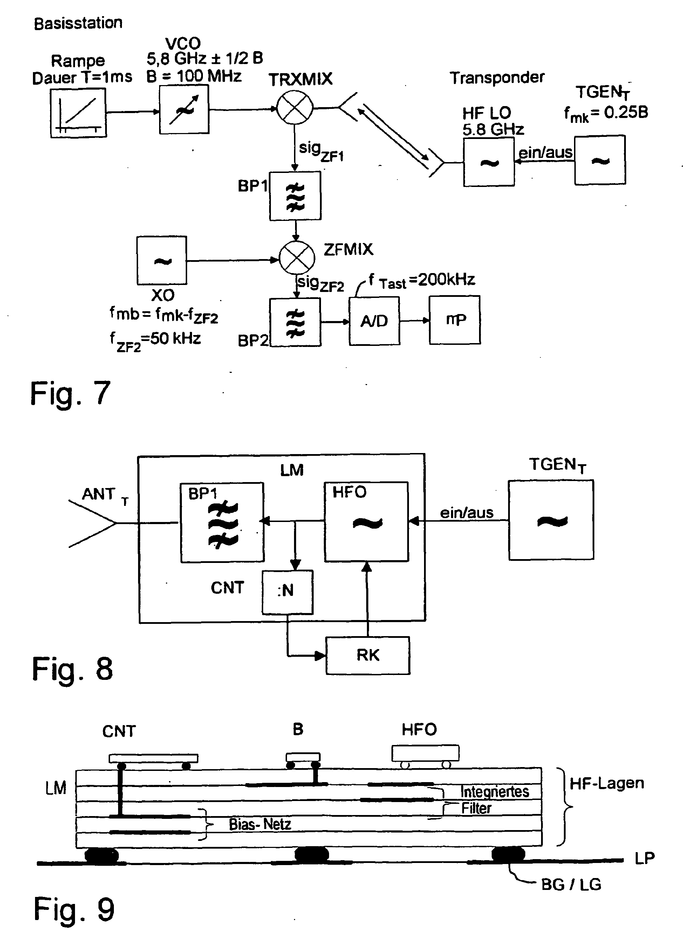

Das erste Maximum, in Fig. 8 z.B. das am nächsten zur Modulationsfrequenz $f_M$ liegende Maximum des oberen Seitenbands 42 aus Fig. 10 ist ein direktes Echosignal vom Transponder, d.h. durch eine direkte Freiraumübertragung ohne Reflexion entstanden. Die weiteren Maxima stellen längere Übertragungswege dar, die durch Reflexionen an Objekten entstehen.

In dem Frequenzbereich um die Mischfrequenz von 0 Hz, die auch als Basisband 41 bezeichnet wird, befinden sich die unmittelbar an Objekten reflektierten Echosignale, wie sie auch bei einem üblichen FMCW-Radar auftreten würden. Diese Echosignale im Basisband 41 sind vorliegend weniger von Interesse.

Der Unterschied der vorliegenden Ausführung gegenüber diesem Stand der Technik besteht nun darin, dass

a) die beiden Seitenbänder hier um den Frequenzanteil Δb verschoben sind, d.h. Seitenband 42' um den Frequenzanteil Δb nach links und Seitenband 42 um den Frequenzanteil Δb nach rechts, so dass die beiden Seitenbänder auch bei der Entfernung 0 nicht ineinander laufen und

b) die Einhüllenden der Spektrallinien jeweils eine Rechteckfunktion der Breite Δp bilden und vorteilhafterweise die inneren Kanten, also die beiden Rechteck-Kanten, die rechts und links am nächsten zur Modulationsfrequenz fm liegen, zur Auswertung herangezogen werden

Besonders vorteilhaft kann der Transponder bei lokalen Positioniersystemen (LPS) eingesetzt werden. Bei den lokalen Positioniersystemen wird der Abstand zu einem Transponder TR von zumindest zwei in ihrer Position bekannten Basisstationen BS gemessen. Durch Triangulation kann dann die Position des Transponders TR in einer Ebenen bzw. bei Verwendung von mehr Basisstationen BS auch im Raum bestimmt werden, dann mit einem Kugelschnittverfahren. Bei lokalen Positioniersystemen ist die dargestellte Möglichkeit, die äußere Kante der Rechteckfunktion zur Bestimmung der Beatfrequenz $f_{beat}$ bzw. der Entfernung dist heranzuziehen insbesondere auch deswegen sehr vorteilhaft, da bei lokalen Positioniersystemen immer maßgeblich die kürzesten Messwege zwischen Basisstation BS und Transponder TR interessant sind. Die bei Systemen nach dem Stand der Technik üblichen Messgenauigkeits-Probleme, die durch Mehrwege-Ausbreitung entstehen, treten bei dem vorliegenden System prinzipbedingt nicht auf, wenn wie vorgeschlagen, die inneren Kanten der Rechteckfunktion zur Auswertung herangezogen werden. Die vorstehend genannten Probleme durch Überlagerung von Spektralkomponenten bei üblichen Systeme und der Vorteil des hier beschriebenen Systems sind in Fig. 5 anschaulich dargestellt.

Bei der in Fig. 5 dargestellten Überlagerung von z.B. 6 Signalkomponenten (1,2,...6) ist ersichtlich, dass im normalen Fall der bestimmte Messwert $f_{mess}$, also das Maximum des Spektrums, nicht der tatsächlichen zur Entfernung proportionalen Frequenz, hier z.B. 100Hz, entspricht. Demgegenüber liegt beim hier beschriebenen System die linke Kante auch bei Überlagerung der Signalkomponenten an der richtigen Position, d.h. es wird ein korrekter Entfernungswert bestimmt.

Ähnlich wie auch schon in "M. Vossiek, R. Roskosch, and P. Heide, Precise 3-D Object Position Tracking using FMCW Radar, 29th European Microwave Conference, Munich, Germany, 1999" für sich genommen dargestellt wurde, wobei von Spitzenwerten ausgegangen wurde, ist es vorteilhaft, den Abstand zwischen den zwei Seitenbändern auszuwerten, da dann die Modulationsfrequenz des Transponders TR, die ja a priori nicht bekannt ist, nicht in die Auswertung mit eingeht. Wird das Messsignal, wie oben schon dargestellt wurde, mit einem klassischen Hüllkurvendemodulator demoduliert, bzw. mit sonstigen Mitteln möglichst exakt auf die Frequenz 0 oder eine andere möglichst exakt bekannte Frequenz gemischt, so ist natürlich auch der Frequenz-Abstand zu einem Seitenband, wie es für sich genommen bei normalen FMCW-Systemen üblich ist, zur Entfernungsbestimmung hinreichend.

Wie generell bei FMCW-Radar ist auch bei dem vorliegenden System darauf zu achten, dass die Frequenzmodulation zur Verhinderung von Störungen vorzugsweise sehr linear verläuft. Grundsätzlich sind die Auswerteverfahren, wie sie bei FMCW-Systemen üblich sind, insbesondere solche mit Störunterdrückung, auf das vorliegende System übertragbar.

Nachfolgend werden weitere vorteilhafte Anordnungen und Verfahren zu Auswertung des in der Basisstation BS empfangenen Signals $s_{rx}(t)$ dargestellt, die sich speziell auf das vorliegende Verfahren beziehen.

Um möglichst exakte Entfernungswerte zu bestimmen, wird folgende bevorzugte Auswertungsvariante vorgeschlagen. Zunächst wir das Messsignal $s_{rx}(t)$ mit einer Fensterfunktion gewichtet. Da durch die Si-Einhüllende im Prinzip schon eine Amplitudenwichtung vorliegt, ist eine Fensterfunktion mit schwacher Wichtung und demzufolge mit geringer Nebenkeulenunterdrückung hinreichend. Geeignete Fensterfunktionen sind für sich bekannt. Die Fensterfunktion soll lediglich zur Verminderung des bekannten ‚Gibbschen Phänomens' führen, also zu einem glatten und oszillationsfreien Verlauf der spektralen Rechteckfunktion. Zur Berechnung des Spektrums ist vorzugsweise die schnelle Fouriertansformation zu verwenden, da ihre Eigenschaften gerade dazu führen, dass die Si-Funktion zu der vorteilhaften spektralen Rechteckfunktion transformiert wird. Vorzugsweise wird der Betrag des Spektrums ausgewertet. Eine Auswertung der Phase, wie sie für sich genommen aus dem Stand der Technik bekannt ist, ist aber ebenso möglich.

Um die Kanten, insbesondere die erste innerste Kante möglichst exakt zu bestimmen, ist es vorteilhaft das Betragsspektrum zu differenzieren, da die steilen Flanken des Rechtecks dann ausgeprägte Spitzen bzw. sogenannte Peaks ergeben. Die Lage der Maxima der Peaks entsprechen dann der Position der Kanten bzw. den Wendepunkten der Kantenfunktion. Durch diese Form der Auswertung wird mit einfachen Mitteln vermieden, dass die Amplitude des Signals einen Einfluss auf die Lage der bestimmten Position bzw. letztendlich der bestimmten Entfernung hat, wie dies bei einfachen Schwellenwertauswertungen der Fall wäre.

Da die Messsignale und Spektren zumeist nur in Zeitdiskretisierter Form vorliegen, ist es ferner vorteilhaft, die Lagebestimmung der Maxima des differenzierten Spektrums mit Hilfe einer Interpolationsrechnung weiter zu verbessern. Eine günstige Interpolation kann z.B. mit einer gängigen Polynomanpassung erfolgen. Vorzugsweise werden hierzu einige der diskreten Spektralpunkte in der direkten Umgebung des Maximums, z.B. 3, d.h. das Maximum und sein rechter und linker Nachbar, und ein Polynom gerader Ordnung verwendet, z.B. 2. Ordnung, d.h. eine Parabel. Andere Interpolationsverfahren, wie etwa Spline-Verfahren, oder solche Verfahren, die zu erwartende Kurvenformen mittels "Least-Squares-Verfahren" an die gemessene Kurve anpassen, sind ebenso verwendbar.

Alle genannten Verfahren können natürlich auch einzeln angewendet oder in anderen Kombinationen die genannten Vorzüge ermöglichen und auch mit anderen bei FMCW-Radaren oder Transpondern bekannten Verfahren kombiniert werden.

Wie dies bereits dargestellt ist, ist die Entfernungsmessung bei der Auswertung der beiden spektralen Seitenbänder unabhängig von der Modulationsfrequenz $f_{mk}$ im Transponder. Die Modulationsfrequenz kann daher dazu verwendet werden, parallel oder anstelle zur Entfernungsmessung Informationen vom Transponder TR zur Basisstation BS zu übertragen. Eine für sich bekannte Frequenzpositionscodierung ist in diesem Sinn besonders geeignet. Hierzu ist der Transponder TR mit Einrichtungen zu versehen, die es ermöglichen, die Modulationsfrequenz $f_{mk}$ in zumindest zwischen zwei Werten zu wechseln.

Ebenso kann es vorteilhaft sein, verschiedene Transponder TR einer Gruppe mit unterschiedlichen Modulationsfrequenz $f_{mk}$ zu versehen, damit sie in einer Basisstation BS sogar bei gleichzeitiger Abfrage eindeutig zu trennen sind. Ein günstiges Schema zu Aufteilung der Frequenzen bei einer Gruppe mit einer Anzahl von K Transpondern und Verwendung eines N-wertigen Codes ist in Fig. 6 dargestellt. Der minimale Abstand $\Delta f_{min}$ zwischen den Modulationsfrequenzen zweier Transponder TR ist so zu wählen, dass sich die Transpondersignale unabhängig vom Code und den Entfernungen zwischen Transponder TR und Basisstation BS spektral nicht überlappen. Die Modulationsschrittweite $\sigma f$ wird vorzugsweise etwas höher als die maximal zu erwartende Frequenzmessunsicherheit gewählt. Dieser Zusammenhang und beispielhafte Ausführungsformen eines entsprechenden Positionscodierungsverfahren sind z.B. aus DE 198 60 058, die ein funkabfragbares Oberflächenwellenelement mit optimalem Codeumfang, für sich genommen bekannt.

Eine günstige Ausführung des Transponders und der Basisstation mit vorteilhafter Wahl der Systemparameter zeigt Fig. 7. Die Sende-/Empfangstrennung erfolgt hier in der Basisstation BS mit einem Transmissionsmischer TRXMIX. Die Modulationsfrequenz $f_{mk}$, hier z.B. 25 MHz, im Transponder TR beträgt vorteilhaft etwa 1/4 der Modulationsbandbreite B, hier also z.B. 100 MHz, eines spannungsgesteuerten Oszillators VCO (Voltage Controlled Oscillator) in der Basisstation BS. Mit dem Bandpassfilter BP1, das um die Modulationsfrequenz $f_{mk}$ zentriert sein sollte, wird zunächst das Transpondersignal von störenden Signalkomponenten befreit. Die Mischfrequenz $f_{mb}$ des Zwischenfrequenz-Mischers ZFMIX wird vorzugsweise so gewählt, dass nicht auf die Frequenz 0 sondern auf eine andere niedrigere Zwischenfrequenz $f_{ZF2}$ gemischt wird. Dieser Zwischenfrequenzbereich wird dann mit dem Bandpassfilter BP2, das um $f_{ZF2}$ zentriert sein sollte, selektiert. Die Zwischenfrequenz $f_{ZF2}$, hier 50 kHz, sollte so gewählt werden, dass alle interessierenden Signalkomponenten, also beide Seitenbänder, bei einem bestimmten gewählten Entfernungsbereich im Frequenzbereich > 0 liegen, so dass auf eine komplexwertige Datenaufnahme und Auswertung verzichtet werden kann. Vorzugsweise werden die Messdaten mit einem Analog-Digital-Wandler digitalisiert und in einem Mikroprozessor verarbeitet. Die Abtastfrequenz, hier z.B. 200 kHz, des Analog-Digital-Wandlers A/D wird vorzugsweise etwa viermal so groß wie die Zwischenfrequenz $f_{ZF2}$ gewählt. Die Funktion des Bandpassfilter BP2 wird vorzugsweise durch ein weiteres digitales Bandpassfilter im Mikroprozessor unterstützt oder sogar ersetzt.

Sollen vom Transponder TR auch Daten zur Basisstation BS übertragen werden oder der Transponder TR, wie vorstehend dargestellt wurde, in einem bestimmten definierbaren Frequenzkanal arbeiten, so wird die Modulationsfrequenz $f_{mk}$ im Transponder TR vorzugsweise mit einem programmierbaren Frequenzsynthesizer erzeugt oder aus einem Grundtakt aus einem programmierbaren Teiler abgeleitet. Die Steuerung der Modulationsfrequenz $f_{mk}$ übernimmt dann vorzugsweise ein Mikroprozessor im Transponder TR.

Zur flexiblen Einstellung der Mischfrequenz $f_{mb}$ in der Basisstation BS und zur Selektion bestimmter Frequenzkanäle über das Bandpassfilter BP2 kann es auch sinnvoll sein, die Mischfrequenz $f_{mb}$ des Zwischenfrequenz-Mischers ZFMIX mit einem programmierbaren Frequenzgenerator zu erzeugen.

Das dargestellte Transpondersystem ist für vielfältige Applikationen einsetzbar und kann selbstverständlich durch verschiedenartigste Verfahren und Komponenten, die im Bereich Transponder und Positioniersysteme dem Stand der Technik entnehmbar sind, ergänzt oder modifiziert werden.

Insbesondere ist das dargestellte Prinzip auch auf den gesamten Bereich elektromagnetischer Wellen, z.B. von wenigen Hz bis in den optischen Bereich, und auch auf andere Wellenformen, z.B. Schall, übertragbar.

Bei den zuvor genannten Applikationen ist es in aller Regel sehr vorteilhaft, wenn die Hochfrequenzmodule und insbesondere der Transponder TR möglichst klein und kompakt aufgebaut sind. Bei Zugangssystemen oder Bezahl-Systemen, bei denen der Transponder TR üblicherweise von einer Person am Körper getragen wird, bestimmt beispielsweise die Baugröße des Transponders TR, z.B. in Form eines Schlüssels oder einer Zahl-/ Eintrittskarte, maßgeblich den Tragekomfort.

Üblicherweise werden Hochfrequenzmodule auf Leiterplatten aus organischen Materialien, z.B. Teflon®- oder Epoxi-basiert, aufgebaut. Insbesondere bei niedrigen HF-Frequenzen, z.B. 1 GHz - 10 GHz, ist der Wunsch nach kleinen Baugrößen aufgrund der Verkopplung zwischen Wellenlänge und Strukturgröße mit diesen Materialien nur sehr eingeschränkt zu erfüllen. Eine Alternative sind Schaltungen auf Dünnschicht-Keramiken, deren Fertigung aber sehr kostenintensiv ist.

Daher lassen sich sowohl der Transponder TR als auch die Basisstation BS besonders vorteilhaft als LTCC-(Low Temperature Cofired Ceramic / Niedertemperatur-gesinterte Keramik) Modul oder unter Verwendung von LTCC-Modulen umsetzen. Die Hochfrequenzstrukturen auf LTCC-Basis sind zum einen wegen der relativ großen Dielektrizitätszahl von LTCC kompakt aber zum anderen auch deswegen, da die Möglichkeit besteht, die Schaltung in Mehrlagentechnik zu realisieren. Die Herstellung von LTCC ist kostengünstig. Außerdem sind LTCC-Module massenfertigungstauglich bestückbar.

Da die komplette HF-Schaltung oder kritische Teilkomponenten vollständig in einem LTCC-Modul integrierbar sind, können diese integrierten LTCC-Module wie Standard-SMT-Bauteile (Surface Mount Technology/Oberflächenmontagetechnologie) auf sehr kostengünstige Standard-Leiterplatten, die ihrerseits nicht unbedingt HF-tauglich sind, bestückt werden. Es besteht natürlich auch die Möglichkeit, die Technologien zu kombinieren und LTCC-Submodule auf Leiterplatten aus organischen Materialien, die dann aber deutlich kleiner sein können, aufzubauen.

Ein vorteilhafter Transponder TR mit LTCC-HF-Modulen ist in Fig. 8 dargestellt. Auf dem LTCC-Modul LM sind beispielsweise ein Hochfrequenz-Oszillator HFO, ein Bandpassfilter BP1 zum Ausfiltern von störenden Modulationskomponenten, die durch das Schalten (ein/aus) des Oszillators HFO mit dem Takt von einem Taktgenerator TGEN entstehen, und ein Hochfrequenz-Teiler oder -Zähler CNT integriert. Über einen Regelkreis RK, dem der heruntergeteilte Takt bzw. der Zählerstand zugeführt wird, wird der Oszillator HFO auf seine Zielfrequenz geregelt, wie dies z.B. anhand Fig. 7 beschrieben ist. Aus dem LTCC-Modul LM werden, bis auf den Anschluß der Antenne $ANT_T$, lediglich digitale, vergleichsweise niederfrequente Signale nach außen geführt, so dass dieses Modul LM problemlos und kostengünstig in die restliche Schaltung integriert werden kann.

Ein möglicher Aufbau des LTCC-Moduls ist in Fig. 9 schematisiert. Die HF-Schaltung besteht dabei aus mehreren Schichten bzw. Hf-Lagen. "Auf die Oberseite des LTCC-Substrates werden die Bauteile bestückt, die nicht in die inneren Schichten zu integrieren sind, in erster Linie z.B. Halbleiter. Dies wären aus der Schaltung von Fig. 8 z.B. der Oszillator HFO, der Teiler CNT und ggf. weitere diskrete Bauteile B. Als Bestückungstechnik bieten sich insbesondere SMT-Bestückung oder Flip-Chip-Bestückung an, wie sie für sich genommen bekannt sind aus [P. Heide: "Business Opportunities and Technology Trends - Millimeterwave Modules for Sensor Products and Broadband Wireless Communications", Compound Semiconductors Magazine, Vol. 6, No. 2, March 2000, pp. 82 - 88.] an. Das LTCC-Modul LM selber kann z.B. mit sogenannter Ball-Grid-oder Land-Grid-Technik BG/LG auf eine Standard Leiterplatte LP moniert werden.

Ein Grundgedanke bei den Ausführungsbeispielen besteht darin, dass nicht nur die Oszillationen des aktiven Oszillators im Transponder TR quasiphasenkohärent zum Basissignal sind, sondern bereits die Anregung des aktiven Oszillators quasiphasenkohärent geschieht. Während bei Vorrichtungen und Verfahren nach dem Stand der Technik das Anregen des aktiven Oszillators durch thermisches Rauschen erfolgt, und seine Oszillationen erst später durch einen aufwendigen Regelprozess und ein Lock-In quasiphasenkohärent gemacht werden, wird beim Gegenstand der Anmeldung der Oszillator durch das Basissignal bereits quasiphasenkohärent angeregt bzw. schwingt bereits quasiphasenkohärent an und es wird damit gleichsam automatisch die Phasenkohärenz hergestellt.

Eine Grundidee besteht darin, dass ein Oszillator sich im Grundzustand in einem labilen Gleichgewicht befindet, und, wenn er eingeschaltet wird, durch eine wie auch immer geartete Fremdenergiezufuhr erst dazu angeregt werden muss, zu schwingen. Erst nach diesem initialen Anstoßen wird die Rückkopplung aktiv; mit der die Schwingung aufrechterhalten wird. Üblicherweise wird zum Beispiel das thermische Rauschen zu einer solchen Initialisierung eines Schwingkreises verwendet. Das heißt, dass ein Oszillator mit einer zufälligen Phase und Amplitude anschwingt und dann bei seiner durch seinen Resonanzkreis vorgegebenen Frequenz oszilliert. Wird in den Oszillator beim Einschalten jedoch ein externes Anregungssignal injiziert, dessen Frequenz in der Bandbreite des Resonanzkreises liegt und dessen Leistung nennenswert oberhalb der Rauschleistung liegt, so schwingt der Oszillator nicht zufällig, sondern synchron mit der Phase des anregenden Basissignals an. Je nach Frequenzdifferenz zwischen dem anregenden Basissignal und dem Oszillatorsignal und in Abhängigkeit vom Phasenrauschen der beiden Oszillatoren bleibt diese Quasiphasenkohärenz zumindest eine Zeit lang bestehen.

Der Unterschied des vorliegenden Konzeptes zu den bekannten passiven Vorrichtungen und Verfahren besteht in der Verwendung eines aktiven Oszillators. So wird das Basissignal nicht einfach zurückgespiegelt, sondern es wird vor dem Zurücksenden mit einer eigenen quasiphasenkohärenten Quelle nahezu rauschfrei ein Oszillatorsignal aktiv konstruiert. Das System hat dabei bei sonst ähnlicher Funktion daher eine signifikant höhere Rechweite als passive Systeme nach dem Stand der Technik.

Das Oszillatorsignal des aktiven Oszillators kann als Antwortsignal oder Vergleichssignal dienen, je nachdem, ob es sich um eine uni- oder bidirektionale Signalüberragung handelt.

Weiterhin kann auf Regelkreise für eine etwaige Trägerrückgewinnung bei der vorliegenden Vorrichtung verzichtet werden. Ein besonderer Vorteil besteht bei Transponderanordnungen darin, dass keinerlei Zeit-, Frequenz- oder Polarisationsmultiplex notwendig ist, da sich das Basis- und Oszillatorsignal gegenseitig nicht beeinflussen, bzw. nur zu Beginn des Einschwingvorganges in gewünschter Art und Weise beeinflussen und danach unabhängig voneinander quasiphasenkohärent sind.

Vorteilhaft ist es, wenn die Vorrichtung ein Schaltmittel zum Schalten der quasiphasenkohärenten Anregbarkeit des aktiven Oszillators aufweist. Dieses Schaltmittel dient dazu, den aktiven Oszillator in einen Zustand zu versetzen, aus dem er, durch das Basissignal angeregt, quasiphasenkohärent zu dem Basissignal anschwingen kann.

Für ein Schalten der Anregbarkeit müssen nicht unbedingt die Oszillationen komplett ein- und ausgeschaltet werden. Wenn zum Beispiel der aktive Oszillator mit unterschiedlichen Moden schwingen kann, kann einfach eine zweite Mode geschaltet werden, während die erste weiterschwingt. Auch bei nur einer Mode muss die Oszillation nicht vollständig abgeschaltet werden, sondern es reicht in der Regel eine Dämpfung, so dass das Basissignal zur nächsten quasiphasenkohärenten Anregung ausreicht.

Wird die Anregbarkeit des aktiven Oszillators nach der Kohärenzzeitlänge erneut eingeschaltet, so bleibt die Quasiphasenkohärenz über einen längeren Zeitraum bestehen.

Wird in Weiterbildung die quasiphasenkohärente Anregbarkeit des aktiven Oszillators zyklisch wiederholt, so bleibt die Quasiphasenkohärenz auch über längere Zeiträume bestehen. Dies kann dadurch erreicht werden, dass das Schaltmittel so ausgebildet ist, dass es den aktiven Oszillator mit einer vorgegebenen Taktrate schaltet.

Vorzugsweise entspricht die Dauer der Taktzyklen der Taktrate dabei in etwa der Kohärenzzeitlänge. Es ist aber auch ein schnelleres Schalten möglich, ohne dass die Quasikohärenz zwischen Basis- und Oszillatorsignal verloren geht. Wenn anders herum die Quasiphasenkohärenz nur in bestimmten Zeitabschnitten notwendig ist, kann die Taktzeit auch länger gewählt werden als die Kohärenzlänge.

Wird das Schalten des aktiven Oszillators zyklisch wiederholt und schwingt der aktive Oszillator zyklisch quasiphasenkohärent zum Basissignal an, so kann das vom aktiven Oszillator erzeugte Oszillatorsignal als ein abgetastetes Duplikat des Basissignals aufgefasst werden. Bei Einhaltung des Abtasttheorems ist ein Signal vollständig durch seine Abtastwerte beschrieben. Sinnvollerweise ist die Ausschaltzeitdauer des aktiven Oszillators nicht deutlich länger als die Einschaltzeitdauer, also nicht deutlich länger als die Kohärenzzeitlänge. Die Einhaltung des Abtasttheorems ergibt sich daher wegen der Kohärenzbedingung immanent. Laut Abtasttheorem muss die Phasendifferenz zwischen zwei Abtastpunkten kleiner als 180° sein. Diese Bedingung ist weniger restriktiv als die Quasikohärenzbedingung. In Konsequenz ist aus informationstechnischer Sicht das Signal des geschalteten Oszillators, trotz des Schaltvorganges, als ein Abbild des Vergleichssignals anzusehen bzw. trägt dessen vollständige Information.

Die Anregbarkeit des aktiven Oszillators lässt sich relativ einfach schalten, indem der Oszillator selbst geschaltet wird. Entsprechend kann die Vorrichtung ein Mittel zum Ein- und Ausschalten des aktiven Oszillators aufweisen. Zum Schalten des Oszillators ist jegliches Mittel geeignet, das bewirkt, dass die Schwingbedingung des Oszillators gegeben bzw. nicht mehr gegeben ist. So kann z.B. im Schwingkreis die Verstärkung abgeschaltet, Dämpfungen oder Laufzeiten (Phasen) verändert oder der Rückkoppelzweig aufgetrennt werden.

Der aktiven Oszillator kann außer auf seiner Grundmode auch quasiphasenkohärent auf einer seiner subharmonische Schwingungsmoden angeregt werden. Zur Anregung kann dabei die Grundmode oder eine subharmonischen Schwingungsmode des Basissignals dienen.

Wird die Vorrichtung zur Identifikation als ID-Tag oder zur Kommunikation verwendet, so kann die Codierung zum Beispiel durch die Taktrate erfolgen und/oder zu eine zusätzliche Modulationseinheit, mit der das quasiphasenkohärente Signal vor dem Zurücksenden moduliert wird.

Wie bereits dargelegt wurde, ist die Kohärenzzeitlänge von der Frequenzdifferenz zwischen Basis- und Oszillatorsignal abhängig. Je genauer die Frequenzen übereinstimmen, desto länger sind die Phasen der Signale nahezu gleich. Um die Kohärenzzeitlänge zu vergrößern, wodurch auch die Taktrate des Schaltmittels gering gehalten werden kann, kann es vorteilhaft sein, Mittel vorzusehen, die dazu geeignet sind, die Oszillatorfrequenz adaptiv an die Frequenz des Basissignals anzupassen.

Bei der Wahl des aktiven Oszillators ist zu beachten, dass seine Einschwingzeit klein gegenüber der Kohärenzzeitlänge sein sollte. Die Güte des Oszillators sollte daher nicht zu groß gewählt werden. Die Güte sollte allerdings auch nicht zu gering gehalten werden, da Oszillatoren mit geringer Güte üblicherweise in hohes Phasenrauschen aufweisen.

Bei einer Anordnung mit einer Vorrichtung zur Erzeugung eines Oszillatorsignals und mit einer Basisstation, in der das Basissignal erzeugt und von der es zur Vorrichtung gesendet wird, kann das Oszillatorsignal von der Vorrichtung als Antwortsignal auf das Basissignal zurück zur Basisstation gesendet werden.

In einer Anordnung, in der die Vorrichtung über Basis- und Oszillatorsignale als Abfrage- und Antwortsignale mit einer Basisstation kommuniziert, weist die Basisstation vorzugsweise ein Bandpassfilter auf, dessen Mittenfrequenz in etwa der Taktrate entspricht, und/oder Mittel, um den Einfluss der Taktrate zu eliminieren. Solche Mittel können ein zusätzlicher Mischer oder ein Gleichrichter und ein Tiefpassfilter sein.

**Patentansprüche**

1. FMCW-Verfahren zum Bestimmen der Entfernung (dist) zwischen einer Basisstation (BS) und zumindest einem Transponder (TR), bei dem

   - von der Basisstation (BS) ein Signal ($s_{tx}$(t)) eines Basisstations-Oszillators ($OSZ_B$) ausgesendet wird, dessen Frequenz während einer Zeitdner T über die Bandbreite B vorstimmt wird
   - im Transponder (TR) auf Basis des von der Basisstation (BS) empfangenen Signals ($e_{rxt}$(t)) mittels eines oszillierenden Oszillators ($OSZ_T$) ein dazu quasiphasenkohärentes Signal ($S_{OSZ}$(t)) erzeugt und ausgesendet wird,
   - in der Basisstation (BS) anhand des von dem Transponder (TR) empfangenen quasiphasenkohärenten Signals ($s_{rx}$(t)) die Entfernung (dist) bestimmt wird,
   - der Oszillator ($OSZ_T$) zum Erzeugen des phasenkohärenten Signals ($s_{osz}$(t)) mit dem von der Basisstation (BS) empfangenen Signal ($e_{rxt}$(t)) quasi-phasenkohärent angeregt wird,
   - die Entfernung (dist) aus der gemessenen Frequenz ($f_{mess}$) bestimmt wird, die der normalen, um einen Frequenzanteil = B*Ts / (2 T)Δb verschobenen gemessenen FMCW-Messfrequenz entspricht, und
   - zum Anregen des Oszillators ($OSZ_T$) der Oszillator ($OSZ_T$) zyklisch ein- und ausgeschaltet wird und der aktive Oszillator ($OSZ_T$) mit einer vorgegebenen Taktrate so geschaltet wird, dass die quasiphasenkohärente Anregbarkeit des aktiven Oszillators ($OSZ_T$) zyklisch wiederholt wird und eine Dauer von Taktzyklen $T_s$ der Taktrate der Kohärenzzeitlänge entspricht oder schneller geschaltet wird.

2. FMCW-Entfernungs-Bestimmungssystem zum Bestimmen der Entfernung (dist) zwischen einer Basisstation(BS) und zumindest einem Transponder (TR), wobei

   - die Basisstation (BS) eine oszillierende Signalquelle ($OSZ_B$) zum Erzeugen eines Signals ($s_{tx}$ (t)) dessen Frequenz während einer Zeitdner T über die Bandbreite B vorstimmt wird, und eine Sendeeinrichtung ($ANT_B$) zum Aussenden des Signals ($s_{tx}$(t)) aufweist,
   - der Transponder (TR) eine Empfangseinrichtung ($ANT_T$) zum Empfangen des Signals ($e_{rxt}$(t)) von der Basisstation (BS), einen aktiven Oszillator ($OSZ_T$) zum Erzeugen eines dazu quasiphasenkohärenten Signals ($s_{osz}$(t)) und eine Sendeeinrichtung ($ANT_T$) zum Aussenden des quasiphasenkohärenten Signals ($s_{osz}$(t)) aufweist,
   - die Basisstation (BS) außerdem eine Empfangseinrichtung ($ANT_B$) zum Empfangen des quasiphasenkohärenten Signals ($s_{osz}$(t)) von dem Transponder (TR) und eine Entfernungs-Bestimmungseinrichtung (RXMIX, FLT, DEMOD) zum Bestimmen der Entfernung (dist) zwischen Basisstation (BS) und Transponder (TR) aufweist,
   - der Oszillator ($OSZ_T$) im Transponder (TR) mit dem von der Basisstation (BS) empfangenen Signal ($e_{rxt}$(t)) zum Erzeugen des quasi-phasenkohärenten Signals ($s_{osz}$(t)) angeregt wird,
   - wobei die Entfernungs-Bestimmungseinrichtung (RXMIX, FLT, DEMOD) zum Bestimmen der Entfernung (dist) aus der gemessenen Frequenz ($f_{mess}$) ausgebildet ist, die der normalen, um einen Frequenzanteil Δb = B*Ts / (2 T) verschobenen gemessenen FMCW-Messfrequenz entspricht, und
   - im Transponder (TR) eine Taktsteuerung 5CLK/Sw) zum Anregen des Oszillators ($OSZ_T$) und zum zyklischen Ein- und Ausschalten des Oszillators ($OSZ_T$) bereitgestellt ist und ein Schaltmittel so ausgebildet ist, dass der aktive Oszillator ($OSZ_T$) mit einer vorgegebenen Taktrate so schaltet, dass die quasiphasenkohärente Anregbarkeit des aktiven Oszillators ($OSZ_T$) zyklisch wiederholt wird und eine Dauer von Taktzyklen $T_s$ der Taktrate der Kohärenzzeitlänge entspricht oder schneller geschaltet wird.

3. FMCW-Entfernungs-Bestimmungssystem nach Anspruch 2, bei dem die Entfernungs-Bestimmungseinrichtung (RXMIX, FLT, DEMOD) in der Basisstation (BS) einen Mischer (RXMIX) zum Mischen des von dem Transponder (TR) empfangenen quasiphasenkohärenten Signals ($s_{rxt}$(t)) und des momentanen Sendesignals ($s_{tx}$(t)) zu einem Mischsignal ($S_{mix}$(t)) aufweist.

4. FMCW-Entfernungs-Bestimmungssystem nach Anspruch 3, bei dem der Mischer (RXMIX) der Entfernungs-Bestimmungseinrichtung (RXMIX, FLT, DEMOD) ausgebildet ist, das Mischsignal ($s_{mix}$(t)) zu bilden durch

$$s_{mix}(t) = \cos(t \cdot \omega_{sw} + \tau \cdot (\omega_c + \omega_{sw}))$$

mit $\omega_c$ als Mittenfrequenz des Basisstations-Oszillators ($OSZ_B$), $\omega_{sw}$ als Modulationsfrequenz des Sendesignals $s_{tx}$ (t) der Basisstation (BS), t als der Zeit im Zeitintervall 0 - Ts und $\tau$ als Laufzeit der Signale über die Entfernung (dist),

zwischen Basisstation (BS) und Transponder (TR).

5. FMCW-Entfernungs-Bestimmungssystem nach einem der Ansprüche 3 oder 4, bei dem die Entfernungs-Bestimmungseinrichtung (RXMIX, FLT, DEMOD) eine Demodulationseinrichtung (DEMOD, GR, TP) zum Reduzieren oder Eliminieren zeitlicher Änderungen der Spannung des Mischsignals ($s_{mix}(t)$) im Zeitintervall (0 - TS) zwischen Ein- und Ausschalten der Messung in der Basisstation (BS) zum Erzeugen eines Messsignals ($s_{mess}(t)$) aufweist.

6. FMCW-Entfernungs-Bestimmungssystem nach einem der Ansprüche 3 bis 5, bei dem die Entfernungs-Bestimmungseinrichtung (RXMIX, FLT, DEMOD) eine Demodulationseinrichtung (DEMOD, ZFMIX, LO, TP) zum Heruntermischen des Mischsignals ($s_{mix}(t)$), insbesondere mit einer Frequenz nahe oder gleich einer Takt-frequenz ($f_{mk}$), auf eine Frequenz deutlich kleiner als der Takt-Frequenz ($f_{mk}$) zum zyklischen Ein- und Ausschalten des Oszillators ($OSZ_T$) im Transponder (TR), und anschließendem Herausfiltern hoher Frequenzanteile zum Erzeugen eines Messsignals ($s_{mess}(t)$) aufweist.

7. FMCW-Entfernungs-Bestimmungssystem nach einem der Ansprüche 2 bis 6, bei dem die Entfernungs-Bestimmungseinrichtung (RXMIX, FLT, DEMOD) ausgebildet ist, die Modulationsfrequenz $\omega_{sw}$ des Sendesignals ($s_{tx}(t)$) der Basisstation (BS) zu modulieren, insbesondere gemäß

$$\omega_{sw} = \frac{2 \cdot \pi \cdot B \cdot t}{T}$$

mit t als Zeit,

8. FMCW-Entfernungs-Bestimmungssystem nach einem der Ansprüche 2 bis 7, bei dem die Entfernungs-Bestimmungseinrichtung (RXMIX, FLT, DEMOD) zum Bilden des resultierenden FMCW-Messsignals ($s_{messfmcw}(t)$) durch

$$s_{messfmcw}(t) = \cos\left(\omega_c \cdot \tau + \frac{2 \cdot \pi \cdot B \cdot t \cdot \tau}{T} + \frac{\pi \cdot B \cdot t \cdot T_s}{T}\right) \cdot \frac{\sin\left(\frac{\pi \cdot B \cdot t \cdot T_s}{T}\right)}{\left(\frac{\pi \cdot B \cdot t}{T}\right)}$$

ausgebildet ist, mit $\omega_c$ als Mittenfrequenz des Basisstations-Oszillators ($OSZ_B$), t als der Zeit, $\tau$ als Laufzeit der Signale über die Entfernung (dist) zwischen Basisstation (BS) und Transponder (TR),

9. FMCW-Entfernungs-Bestimmungssystem nach einem der Ansprüche 2 bis 8, bei dem die Entfernungs-Bestimmungseinrichtung (RXMIX, FLT, DEMOD) zum Durchführen einer Fouriertransformation des amplitudengewichteten Messsignals ($S_{messfmcw}(t)$) in den Frequenzbereich ausgerichtet ist, so dass Kanten eines linken und rechten Seitenbandes zumindest einer entstehenden Rechteckfunktion die Entfernung zwischen Basisstation (BS) und Transponder (TR) bestimmen.

10. FMCW-Entfernungs-Bestimmungssystem nach einem der Ansprüche 2 bis 9, wobei die Signalerzeugungseinrichtung ($OSZ_T$, CLK/Sw) zum Erzeugen eines Oszillatorsignals ($s_{osz}(t)$) aus einem Transponder-Empfangssignal ($e_{rxt}(t) = s_{tx}(t-\tau/2)$) mit einem Oszillator ($OSZ_T$) und einer Tobtstenerung (CLK/Sw) zum zyklischen Ein- und Ausschalten des Oszillators ($OSZ_T$), das Oszillatorsignal gemäß

$$s_{rx}(t) = s_{osz}(t - \frac{\tau}{2}) = \sin(\omega_{osz} \cdot t - (\omega_c + \omega_{sw}) \cdot \tau + \phi_o)$$

erzugt,
mit $\omega_c$ als Mittenfrequenz des Basisstations-Oszillators ($OSZ_B$), $\omega_{sw}$ als Modulationsfrequenz des Sendesignals ($s_{tx}(t)$) der Basisstation (BS), t als der Zeit, $\tau$ als Laufzeit der Signale über die Entfernung (dist) zwischen Basisstation (BS) und Transponder (TR), $\omega_{osz}$ als Schwingfrequenz des Transponders (TR) und $\phi_0$ als beliebigem Phasenoffset.

**11.** FMCW-Entfernungs-Bestimmungssystem nach einem der Ansprüche 2 - 10, bei dem eine Modulation ($f_{mk}$) zum Ein- und Ausschalten des Oszillators ($OSZ_T$) im Transponder (TR) zum Übertragen von zusätzlichen Informationen vom Transponder (TR) zur Basisstation (BS) verwendet wird.

**12.** FMCW-Entfernungs-Bestimmungssystem nach einem der Ansprüche 2 - 11, bei dem eine Modulation ($f_{mk}$) zum Ein- und Ausschalten des Oszillators ($OSZ_T$) im Transponder (TR) jedem einzelnen einer Vielzahl von Transpondern (TR) individuell zugewiesen wird.

**Claims**

**1.** FMCW-Method for determining the distance (dist) between a base station (BS) and at least one transponder (TR), in which

- a signal ($s_{tx}${(t) the frequency of which is modulated over a period of time T across the bandwidth B, from a base station oscillator ($OSZ_B$) is transmitted by the base station (BS),
- in the transponder (TR) by means of an oscillating oscillator ($OSZ_T$) a signal ($s_{osz}$(t)) is generated and transmitted, which is quasi phase-coherent with and based on the signal ($e_{rxt}$(t)) received from the base station (BS),
- in the base station (BS), the distance (dist) is determined by means of the quasi phase-coherent signal ($s_{rx}$(t)) received from the transponder (TR),
- the oscillator ($OSZ_T$) for generating the phase-coherent signal ($s_{osz}$(t)) is excited quasi-phase-coherently with the received signal $e_{rxt}$(t)),
- the distance (dist) is determined from the measured frequency ($f_{mess}$), which corresponds to the normal measured FMCW measurement frequency displaced by a frequency component $\Delta b = B*Ts / (2\ T)$, and
- for exciting the oscillator ($OSZ_T$), the oscillator ($OSZ_T$) is cyclically switched on and off, and the active oscillator ($OSZ_T$) is switched with a pre-determined clock rate such that the quasi phase-coherent excitability of the active oscillator ($OSZ_T$) is cyclically repeated and a duration of clock cycles Ts of the clock rate corresponds to the coherency time length or is switched faster.

**2.** FMCW-Distance determination system for determining the distance (dist) between a base station (BS) and at least one transponder (TR), in which

- the base station (BS) has an oscillating signal source ($OSZ_B$) for generating a signal ($s_{tx}$(t)), the frequency of which is modulated over a period of time T across the bandwidth B, and a transmission device ($ANT_B$) for transmitting the signal ($s_{tx}$(t)),
- the transponder (TR) comprises a receiving device ($ANT_T$) for receiving the signal·($e_{rxt}$(t)) from the base station (BS), an active oscillator ($OSZ_T$) for generating a signal ($s_{osz}$(t)) which is quasi-phase-coherent with it, and a transmission device ($ANT_T$) for transmitting the quasi-phase-coherent signal ($s_{osz}$(t)),
- the base station (BS) comprises in addition a receiving device ($ANT_B$) for receiving the quasi-phase-coherent signal ($s_{osz}$(t)) from the transponder (TR) and distance determination equipment (RMIX, FLT, DEMOD) for determining the distance (dist) between the base station (BS) and the transponder (TR),
- the oscillator ($OSZ_T$} in the transponder (TR) is excited with the received signal ($e_{rxt}$ (t)) for generating the quasi-phase-coherent signal ($s_{osz}$(t)),
- in which the distance determination equipment (RMIX, FLT, DEMOD) is designed for determining the distance (dist) from the measured frequency ($f_{mess}$), which corresponds to the normal measured FMCW measurement frequency displaced by a frequency component $\Delta b = B*Ts / (2\ T)$, and
- in the transponder (TR) a clock controller (CLK/sw) is provided for exciting the oscillator ($OSZ_T$) and for cyclically switching on and off the oscillator ($OSZ_T$), and a switching device is designed such that the active oscillator ($OSZ_T$) switches with a pre-determined clock rate such that the quasi-phase-coherent excitability of the active oscillator ($OSZ_T$) is cyclically repeated and a duration of clock cycles Ts of the clock rate corresponds to the coherency time length or is switched faster.

**3.** FMCW-Distance determination system according to claim 2, in which the distance determination equipment (RXMIX, FLT, DEMOD) in the base station (BS) comprises a mixer (RXMIX) for mixing the quasi-phase-coherent signal ($s_{rxt}$(t)) received from the transponder (TR) and the instantaneous transmit signal ($s_{tx}$(t)) to form a mixture signal ($s_{mix}$(t)).

**4.** FMCW-Distance determination system in accordance with claim 3, in which the mixer (RXMIX) of the distance determination equipment (RXMIX, FLT, DEMOD) is constructed to form the mixture signal ($s_{mix}$(t)) given by

$$s_{mix}(t) = \cos(t \cdot \omega_{sw} + \tau \cdot (\omega_c + \omega_{sw}))\,,$$

where $\omega_c$ is the central frequency of the base station oscillator ($OSZ_B$), $\omega_{sw}$ is the modulation frequency of the transmit signal $s_{tx}(t)$ from the base station (BS), t is the time in the time interval 0 - Ts, and $\tau$ is the time for the propagation of the signals over the distance (dist) between the base station (BS) and the transponder (TR).

5. FMCW-Distance determination system in accordance with claim 3 or 4, in which the distance determination equipment (RXMIX, FLT, DEMOD) has demodulation equipment (DEMOD, GR, TP) for reducing or eliminating changes in time in the voltage of the mixture signal ($s_{mix}(t)$), over the time interval (0 - TS) between the measurement being switched on and switched off in the base station (BS), for the generation of a measurement signal ($S_{mess}(t)$).

6. FMCW-Distance determination system in accordance with one of claims 3 to 5, in which the distance determination equipment (RXMIX, FLT, DEMOD) has demodulation equipment (DEMOD, ZFMIX, LO, TP) for mixing down the mixture signal ($s_{mix}(t)$), in particular with a frequency near to or the same as a clock frequency ($f_{mk}$), to a frequency significantly lower than the clock frequency ($f_{mk}$), for switching the oscillator ($OSZ_T$) in the transponder (TR) cyclically on and off, followed by the filtering out of high frequency components to generate a measurement signal ($s_{mess}(t)$).

7. FMCW-Distance determination system in accordance with one of claims 2 to 6, in which the distance determination equipment · (RXMIX, FLT, DEMOD) is constructed to modulate the modulation frequency $\omega_{sw}$ of the transmit signal ($s_{tx}(t)$) of the base station (BS), in particular in accordance with

$$\omega_{sw} = \frac{2 \cdot \pi \cdot B \cdot t}{T}$$

where t is the time.

8. FMCW-Distance determination system in accordance with one of claims 2 to 7, in which the distance determination equipment (RXMIX, FLT, DEMOD) is constructed to form the resulting FMCW measurement signal ($S_{messfmcw}(t)$) by

$$s_{messfmcw}(t) = \cos\left(\omega_c \cdot \tau + \frac{2 \cdot \pi \cdot B \cdot t \cdot \tau}{T} + \frac{\pi \cdot B \cdot t \cdot T_s}{T}\right) \cdot \frac{\sin\left(\dfrac{\pi \cdot B \cdot t \cdot T_s}{T}\right)}{\left(\dfrac{\pi \cdot B \cdot t}{T}\right)}$$

with $\omega_c$ being the central frequency of the base station oscillator ($OSZ_B$), t being the time, $\tau$ being the time for the propagation of the signals over the distance (dist) between the base station (BS) and the transponder (TR).

9. FMCW-Distance determination system in accordance with one of claims 2 to 8, in which the distance determination equipment {RXMIX, FLT, DEMOD) is designed for the performance of a Fourier transformation of the amplitude weighted measurement signal ($S_{messfmcw}(t)$) in the frequency domain, so that edges of a left and a right sideband of at least one square-wave function which results determine the distance between the base station (BS) and the transponder (TR).

10. FMCW-Distance determination system in accordance with one of claims 2 to 9, in which the signal generation equipment ($OSZ_T$, CLK/Sw) for generating an oscillator signal ($s_{osz}(t)$) from a signal received by the transponder (e=t(t) = $s_{tx}(t-\tau/2)$) uses an oscillator ($OSZ_T$) and a switching device (CLK/Sw) for switching the oscillator ($OSZ_T$) cyclically on and off, generates the oscillator signal according to

$$s_{rx}(t) = s_{osz}(t - \frac{\tau}{2}) = \sin(\omega_{osz} \cdot t - (\omega_c + \omega_{sw}) \cdot \tau + \phi_o),$$

where $\omega_c$ is the central frequency of the base station oscillator (OSZ$_B$), $\omega_{sw}$ is the modulation frequency of the transmit signal (s$_{tx}$(t)) from the base station (BS), t is the time, $\tau$ is the time for the propagation of the signals over the distance (dist) between the base station (BS) and the transponder (TR), $\omega_{osz}$ is a oszillating frequency of the transponder (TR), and $\Phi_o$ is an arbitrary phase offset.

11. FMCW-Distance determination system in accordance with one of claims 2 to 10, in which a modulation (f$_{mk}$) is used for switching the oscillator (OSZ$_T$) in the transponder (TR) on and off, for transmitting additional information from the transponder (TR) to the base station (BS).

12. FMCW-Distance determination system in accordance with one of claims 2 to 11, in which a modulation (f$_{mk}$) for switching the oscillator (OSZ$_T$) in the transponder (TR) on and off is assigned individually to each one of a plurality of transponders (TR).

**Revendications**

1. Procédé FMCW pour déterminer la distance (dist) entre une station de base (BS) et au moins un transpondeur (TR), dans lequel

- un signal (s$_{tx}$(t)) d'un oscillateur de station de base (OSZ$_B$), dont la fréquence est modulée sur la largeur de bande B pendant une durée T, est émis par la station de base (BS),
- dans le transpondeur (TR), un signal (s$_{osz}$(t)) en quasi-cohérence de phase avec le signal (e$_{rxt}$(t)) reçu de la station de base (BS) est généré au moyen d'un oscillateur (OSZ$_T$) oscillant et émis,
- la distance (dist) est déterminée dans la station de base (BS) à l'aide du signal (s$_{rx}$(t)) en quasi-cohérence de phase reçu du transpondeur (TR),
- l'oscillateur (OSZ$_T$) est excité en quasi-cohérence de phase avec le signal (e$_{rxt}$(t)) reçu de la station de base (BS) pour générer le signal en cohérence de phase (s$_{osz}$(t)),
- la distance (dist) est déterminée à partir de la fréquence mesurée (f$_{mess}$) qui correspond à la fréquence de mesure FMCW mesurée normale, décalée d'une composante fréquentielle $\Delta b = B{*}Ts / (2\,T)$, et
- pour exciter l'oscillateur (OSZ$_T$), l'oscillateur (OSZ$_T$) est activé et désactivé cycliquement et l'oscillateur (OSZ$_T$) actif est commuté à une fréquence d'horloge prédéfinie de façon que l'excitabilité en quasi-cohérence de phase de l'oscillateur (OSZ$_T$) actif soit répétée cycliquement et qu'une durée de cycles d'horloge Ts de la fréquence d'horloge corresponde à la longueur du temps de cohérence ou est commuté plus rapidement.

2. Système de détermination de distance FMCW pour déterminer la distance (dist) entre une station de base (BS) et au moins un transpondeur (TR), dans lequel

- la station de base (BS) présente une source de signaux oscillante (OSZ$_B$) pour générer un signal (s$_{tx}$(t)) dont la fréquence est modulée sur la largeur de bande B pendant une durée T, et un dispositif d'émission (ANT$_B$) pour émettre le signal (s$_{tx}$(t)),
- le transpondeur (TR) présente un dispositif de réception (ANT$_T$) pour recevoir le signal (e$_{rxt}$(t)) de la station de base (BS), un oscillateur (OSZ$_T$) actif pour générer un signal (s$_{osz}$(t)) en quasi-cohérence de phase avec celui-ci et un dispositif d'émission (ANT$_T$) pour émettre le signal (s$_{osz}$(t)) en quasi-cohérence de phase,
- la station de base (BS) présente en outre un dispositif de réception (ANT$_B$) pour recevoir le signal en quasi-cohérence de phase (s$_{osz}$(t)) du transpondeur (TR) et un dispositif de détermination de distance (RXMIX, FLT, DEMOD) pour déterminer la distance (dist) entre station de base (BS) et transpondeur (TR),
- l'oscillateur (OSZ$_T$) dans le transpondeur (TR) est excité avec le signal (e$_{rxt}$(t)) reçu de la station de base (BS) pour générer le signal en quasi-cohérence de phase (s$_{osz}$(t)),
- le dispositif de détermination de distance (RXMIX, FLT, DEMOD) étant conçu pour déterminer la distance (dist) à partir de la fréquence mesurée (f$_{mess}$) qui correspond à la fréquence de mesure FMCW mesurée normale, décalée d'une composante fréquentielle $\Delta b = B{*}Ts / (2\,T)$, et
- dans le transpondeur (TR), une commande d'horloge (CLK/Sw) étant prévue pour exciter l'oscillateur (OSZ$_T$)

et pour activer et désactiver cycliquement l'oscillateur (OSZ$_T$) et un moyen de commutation conçu de façon que l'oscillateur (OSZ$_T$) actif soit commuté de façon que l'excitabilité en quasi-cohérence de phase de l'oscillateur (OSZ$_T$) actif soit répétée cycliquement et qu'une durée de cycles d'horloge Ts de la fréquence d'horloge corresponde à la longueur du temps de cohérence ou soit commuté plus rapidement.

3. Système de détermination de distance FMCW selon la revendication 2, dans lequel le dispositif de détermination de distance (RXMIX, FLT, DEMOD) dans la station de base (BS) présente un mélangeur (RXMIX) pour mélanger le signal en quasi-cohérence de phase (s$_{rxt}$(t)) reçu du transpondeur (TR) et le signal d'émission (s$_{tx}$(t)) momentané en un signal mixte (s$_{mix}$(t)).

4. Système de détermination de distance FMCW selon la revendication 3, dans lequel le mélangeur (RXMIX) du dispositif de détermination de distance (RXMIX, FLT, DEMOD) est conçu pour former le signal mixte (s$_{mix}$(t)) par

$$s_{mix}(t) = \cos\left(t \cdot \omega_{sw} + \tau \cdot (\omega_c + \omega_{sw})\right)$$

où $\omega_c$ est la fréquence centrale de l'oscillateur de station de base (OSZ$_B$), $\omega_{sw}$ la fréquence de modulation du signal d'émission s$_{tx}$(t) de la station de base (BS), t le temps dans l'intervalle de temps 0 - Ts et $\tau$ le temps de parcours des signaux sur la distance (dist) entre station de base (BS) et transpondeur (TR).

5. Système de détermination de distance FMCW selon une des revendications 3 ou 4, dans lequel le dispositif de détermination de distance (RXMIX, FLT, DEMOD) présente un dispositif de démodulation (DEMOD, GR, TP) pour réduire ou éliminer des variations dans le temps de la tension du signal mixte (s$_{mix}$(t)) dans l'intervalle de temps (0 - Ts) entre activation et désactivation de la mesure dans la station de base (BS) pour générer un signal de mesure (s$_{mess}$(t))·

6. Système de détermination de distance FMCW selon une des revendications 3 à 5, dans lequel le dispositif de détermination de distance (RXMIX, FLT, DEMOD) présente un dispositif de démodulation (DEMOD, ZFMIX, LO, TP) pour abaisser par mélange le signal mixte (s$_{mix}$(t)), en particulier avec une fréquence proche ou égale à une fréquence d'horloge (f$_{mk}$), à une fréquence nettement plus petite que la fréquence d'horloge (f$_{mk}$) pour l'activation et la désactivation cyclique de l'oscillateur (OSZ$_T$) dans le transpondeur (TR) et pour éliminer ensuite par filtrage les composantes fréquentielles élevées pour générer un signal de mesure (s$_{mess}$(t))·

7. Système de détermination de distance FMCW selon une des revendications 2 à 6, dans lequel le dispositif de détermination de distance (RXMIX, FLT, DEMOD) est conçu pour moduler la fréquence de modulation $\omega_{sw}$ du signal d'émission (s$_{tx}$(t)) de la station de base (BS), en particulier selon

$$\omega_{sw} = \frac{2 \cdot \pi \cdot B \cdot t}{T}$$

où t est le temps.

8. Système de détermination de distance FMCW selon une des revendications 2 à 7, dans lequel le dispositif de détermination de distance (RXMIX, FLT, DEMOD) est conçu pour former le signal de mesure FMCW résultant (s$_{messfmcw}$(t)) par

$$s_{mess_{fmcw}}(t) = \cos\left(\omega_c \cdot \tau + \frac{2 \cdot \pi \cdot B \cdot t \cdot \tau}{T} + \frac{\pi \cdot B \cdot t \cdot T_s}{T}\right) \cdot \frac{\sin\left(\dfrac{\pi \cdot B \cdot t \cdot T_s}{T}\right)}{\left(\dfrac{\pi \cdot B \cdot t}{T}\right)}$$

où $\omega_c$ est la fréquence centrale de l'oscillateur de station de base (OSZ$_B$), t le temps, $\tau$ le temps de parcours des signaux sur la distance (dist) entre station de base (BS) et transpondeur (TR).

9. Système de détermination de distance FMCW selon une des revendications 2 à 8, dans lequel le dispositif de détermination de distance (RXMIX, FLT, DEMOD) est conçu pour effectuer une transformation de Fourier du signal de mesure (s$_{messfmcw}$(t)) pondéré en amplitude dans la plage de fréquence, de façon que les bords d'une bande latérale gauche et droite d'au moins une fonction rectangulaire obtenue déterminent la distance entre station de base (BS) et transpondeur (TR).

10. Système de détermination de distance FMCW selon une des revendications 2 à 9, dans lequel le dispositif de génération de signal (OSZ$_T$, CLK/Sw) est conçu pour générer un signal d'oscillateur (s$_{osz}$(t)) à partir d'un signal de réception de transpondeur (e$_{rxt}$(t) = s$_{tx}$(t - $\tau$/2)) avec un oscillateur (OSZ$_T$) et une commande d'horloge (CLK/Sw) pour activer et désactiver cycliquement l'oscillateur (OSZ$_T$) selon

$$s_{rx}(t) = s_{osz}(t - \frac{\tau}{2}) = \sin(\omega_{osz} \cdot t - (\omega_c + \omega_{sw}) \cdot \tau + \phi_0)$$

où $\omega_c$ est la fréquence centrale de l'oscillateur de station de base (OSZ$_B$), $\omega_{sw}$ la fréquence de modulation du signal d'émission s$_{tx}$(t) de la station de base (BS), t le temps, $\tau$ le temps de parcours des signaux sur la distance (dist) entre station de base (BS) et transpondeur (TR), $\omega_{osz}$ la fréquence d'oscillation du transpondeur (TR) et $\phi_0$ un décalage de phase quelconque.

11. Système de détermination de distance FMCW selon une des revendications 2 à 10, dans lequel une modulation (f$_{mk}$) est utilisée pour activer et désactiver l'oscillateur (OSZ$_T$) dans le transpondeur (TR) pour transmettre des informations supplémentaires du transpondeur (TR) à la station de base (BS).

12. Système de détermination de distance FMCW selon une des revendications 2 à 11, dans lequel une modulation (f$_{mk}$) pour activer et désactiver l'oscillateur (OSZ$_T$) dans le transpondeur (TR) est affectée individuellement à chacun d'une pluralité de transpondeurs (TR).

## Fig. 1

Basisstation

BS

$OSZ_B$  $s_{tx}(t)$  K  RK  $s_{tx}(t)$  $ANT_B$  $s_{rx}(t)$

RXMIX

$s_{mess}(t)$  DEMOD  FLT  $s_{mix}(t)$

dist

Transponder

TR

CLK/Sw  ein/aus

$e_{rxt}(t)$  $ANT_T$  $OSZ_T$

$s_{OSZ}(t)$

## Fig. 2

DEMOD

$s_{mix}(t)$  GR  TP  $s_{mess}(t)$

## Fig. 3

DEMOD  LOZF

LO  TP

$s_{mix}(t)$  ZFMIX  $s_{mess}(t)$

## Fig. 6

σf  Δf min

C1 C2 ... CN  C1 C2 ... CN  ...  C1 C2 ... CN

TR1:Transponder 1 Band 1  TR2:Transponder 2 Band 2  TRk:Transponder K Band K

Fig. 4

Fig. 5

Basisstation

Rampe
Dauer T=1ms

VCO
5,8 GHz ± 1/2 B
B = 100 MHz

TRXMIX

Transponder

HF LO
5.8 GHz

$TGEN_T$
$f_{mk}= 0.25B$

ein/aus

$sig_{ZF1}$

BP1

XO
$f_{mb}= f_{mk}-f_{ZF2}$
$f_{ZF2}$=50 kHz

ZFMIX

$sig_{ZF2}$

$f_{Tast}$=200kHz

BP2

A/D

µP

# Fig. 7

LM

$ANT_T$

BP1

HFO

$TGEN_T$

ein/aus

CNT

:N

RK

# Fig. 8

CNT

B

HFO

LM

Integriertes
Filter

HF-Lagen

Bias- Netz

LP

BG / LG

# Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19946161
- DE 19957536
- DE 19957557
- DE 19957549
- DE 19946161 A1
- US 2786996 A
- WO 0167625 A1
- DE 19860058

**In der Beschreibung aufgeführte Nicht-Patentliteratur**

- **K. FINKENZELLER.** RFID-Handbuch. Carl Hanser Verlag, 2000
- **M. VOSSIEK ; R. ROSKOSCH ; P. HEIDE.** Precise 3-D Object Position Tracking using FMCW Radar. *29th European Microwave Conference,* 1999
- **P. HEIDE.** Business Opportunities and Technology Trends - Millimeterwave Modules for Sensor Products and Broadband Wireless Communications. *Compound Semiconductors Magazine,* Marz 2000, vol. 6 (2), 82-88